# EUROPEAN PATENT APPLICATION

(11) **EP 4 575 533 A1**
(43) Date of publication of application: **25.06.2025**
(21) Application number: 24207019.1
(22) Date of filing: 16.10.2024
(51) Int. Cl.: G01R 31/317, G01R 31/28, G05F 1/10

(54) **AUTO TUNING FOR TESTER DUT POWER SUPPLY**

(30) Priority: 18.12.2023 US 202318544242
(71) Applicant: INTEL Corporation, Santa Clara, CA 95054 (US)
(72) Inventor: THIRUVENGADAM, Bharani, Portland, 97225 (US); INMAN, Bradly, Hillsboro, 97124 (US)
(74) Representative: HGF

(57) **Abstract**

Methods and apparatus for auto tuning for tester DUT Power Supply (DPS). The DPS includes one or more voltage rail blocks that employ DUT voltage feedback and output a voltage rail that is supplied to a DUT on a load board. The voltage rail block includes an amplifier coupled to compensator circuitry, which in turn is coupled to an output control and driver block that outputs a voltage rail. I/O interfaces are provided to receive a voltage signal corresponding to the voltage rail at the DUT input, where the analog voltage signal is used as a DUT voltage feedback and a digitized voltage signal is used by a DPS controller that provides loop compensation parameters to adjust capacitor and resistors and gain in the compensator circuitry to tune the voltage rail to meet signal characteristics defined by an objective function such as voltage rise time, voltage overshoot, voltage undershoots, and settling time.

## Description

### BACKGROUND INFORMATION

A key aspect of DUT (Device Under Test) Power Supply (DPS) for HDMT (High Density Modular Tester) instrument development involves tuning the compensator for maximizing performance under stable operating conditions of the supply. The complexity of the task arises from having different paths to the DUT in different module environments such as environments including a test head or prober that require unique tuning parameters for various resource types (High Current Rail vs Low Current Rail vs Very Low Current Rail) due to varying load and decoupling conditions, differing voltage and current ranges per resource type, and different load board variants (customer xlUs and calibration boards). Today there are nearly 100 combinations that need to be tuned and validated. This is a highly iterative tuning process that needs to be repeated when new versions of supplier silicon are released and when any variations on the instrument or load board arise that could impact path parasitics.

Additional complexity arises from the number of discrete settings that need to be varied to find the optimal tuning for each path. For example, there are 6 degrees of freedom in chips that employ type-3 compensators, which further increases complexity, making an intuitive/manual tuning methodology very time consuming and the task of finding optimal settings nearly impossible.

When developing a new DPS instrument, establishing capable tuning parameter sets for all use environments typically takes multiple quarters to over a year to complete. Incorrect tuning from human error has led to sightings at High Volume Manufacturing, resulting in costly task forces and the need to retune post-tester fleet deployment.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein like reference numerals refer to like parts throughout the various views unless otherwise specified:
Figure 1a is a diagram of a tester and load board connected through a cable system
Figure 1b is a diagram of a tester and load connected through connectors
Figure 2 is a graph illustrating four time-based parameters that provide a measure for stability and performance of DPS instruments;
Figure 3 is a diagram illustrating an example of a test system including a DUT power supply, according to one embodiment;
Figure 3a is a diagram illustrating another example of a test system including a DUT power supply including one or more onboard analog-to-digital converters (ADCs): according to one embodiment;
Figure 3b is a diagram illustrating another example of a test system including a DUT power supply installed on a DPS instrument board one which one or more ADCs are installed, according to one embodiment;
Figure 4 is a diagram illustrating a test system including a DUT power supply providing multiple voltage rails, according to one embodiment;
Figure 4a is a diagram illustrating a version of the DUT power supply of Figure 4 including one or more on-board ADCs, according to one embodiment;
Figure 5 is a flowchart illustrating operations and logic implemented by a DPS controller to tune a voltage rail to meet signal characteristics defined by an objective function, according to one embodiment;
Figure 6 is a diagram illustrating circuitry for a first example of a Type-3 compensator;
Figure 7a is a diagram illustrating circuitry for a second example of a Type-3 compensator;
Figure 7b is a diagram illustrating circuitry for an example of a Type-2 compensator; and
Figure 8 is a diagram illustrating further details of a DPS controller, according to one embodiment.

### DETAILED DESCRIPTION

Embodiments of methods and apparatus for auto tuning for tester DUT Power Supply are described herein. In the following description, numerous specific details are set forth to provide a thorough understanding of embodiments of the invention. One skilled in the relevant art will recognize, however, that the invention can be practiced without one or more of the specific details, or with other methods, components, materials, *etc.* In other instances, well-known structures, materials, or operations are not shown or described in detail to avoid obscuring aspects of the invention.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

For clarity, individual components in the Figures herein may also be referred to by their labels in the Figures, rather than by a particular reference number. Additionally, reference numbers referring to a particular type of component (as opposed to a particular component) may be shown with a reference number followed by "(typ)" meaning "typical." It will be understood that the configuration of these components will be typical of similar components that may exist but are not shown in the drawing Figures for simplicity and clarity or otherwise similar components that are not labeled with separate reference numbers. Conversely, "(typ)" is not to be construed as meaning the component, element, *etc.* is typically used for its disclosed function, implement, purpose, *etc.*

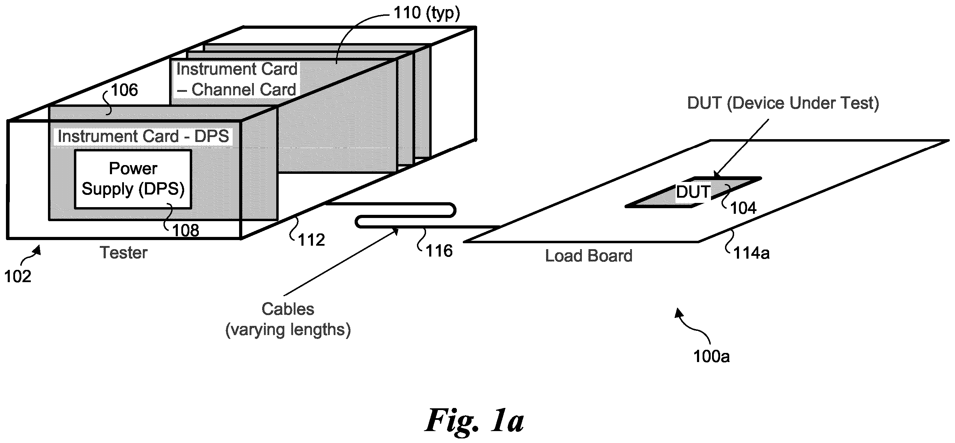

Figure 1a shows an example of a test system 100a including a tester 102 that is used to test a device under test (DUT) 104. Test system includes multiple instrument card including a DUT power supply (DPS) instrument card 106 having a DPS 108 and one or more channel cards 110 that are installed in a chassis 112. DUT 104 is installed on a load board 114a. Load board 114a is connected to tester 102 via cables 116. Generally, the length, configuration, types, and number of cables 116 may vary depending on the test environment and DUT.

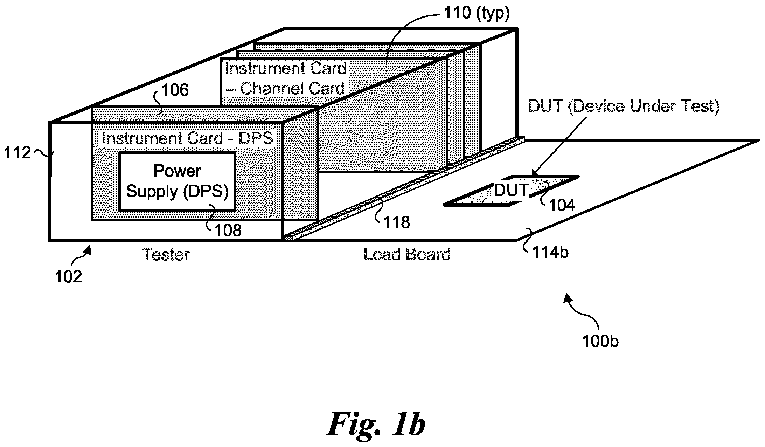

Figure 1b shows a test system 100b having an alternative configuration where a load board 114b is coupled to tester 102 via one or more connectors 118. Generally, test systems 100a and 100b are simplified representations of test systems for performing DUT testing and will include various other components that are known in the art and are left out here for clarity and simplification.

Generally, DUT can be any device suitable for electronic testing. For, instance, nonlimiting examples of DUTs include processors, system on a chip (SoCs), system on package (SoPs), other processing units (XPUs), and other types of integrated circuits and packages. DUT testing may be used for various purposes, such as high-volume manufacturing screen, qualification testing, batch testing, and post-production testing. For example, devices such as processors, SoCs, and SoPs are tested for quality control and other purposes.

DPS instrument card 106 is used to provide one or more input voltages to DUT 104 (via load board 114a or 114b and the applicable connection path). Tester 102 is designed to handle testing of different DUTs under different test environments and configurations. These different test environments and configurations present challenges as, for instance, a difference in cable length and/or type may affect the stability and performance of the DPS instruments.

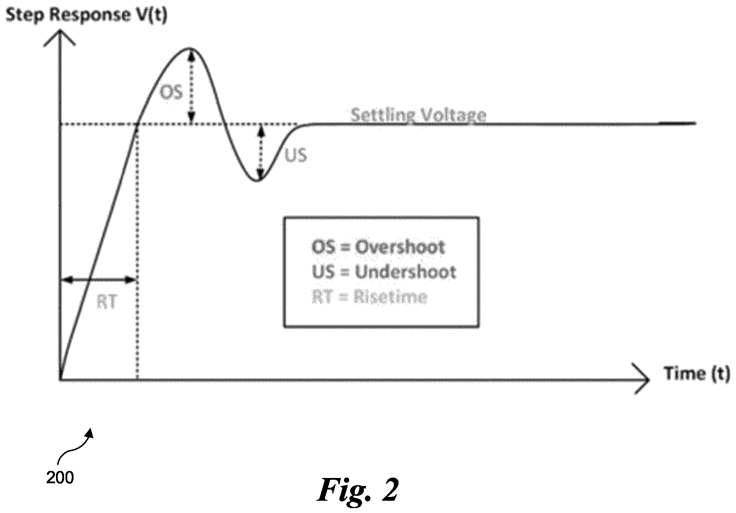

Figure 2 shows a graph 200 illustrating four time-based parameters that provide a measure for stability and performance of DPS instruments: Rise time, Overshoot/Undershoot, Settling time and DC error/accuracy. These parameters inversely relate to frequency domain measurements of bandwidth, phase margin and DC gain. Not meeting these parameter specifications leads to product bin split loss or DPS instrument stability issues that make a product untestable. With ADCs (Analog to Digital Converters) designed onto the instrument board or integrated into the externally-supplied DPS components, these parameters can be measured via a search algorithm that finds the optimal tuning settings.

In accordance with an aspect of the embodiments described herein, an optimization objective function based on weights assigned to the time-based parameters is provided that helps to find the right tuning parameters based on one or more desired goal(s). For example, if stability is a bigger concern, then reduction of rise time becomes a key goal thereby improving the phase margin as well. If, however, improvement of bandwidth and hence vdroops is required, then increase in rise time becomes a key goal. If all four time-based parameters are critical, then equal weights for all parameters are used. The actual algorithm and weights used would be determined by the DPS chips architecture, order of the compensator and specific characteristics of the design.

In some embodiments, measurement of the parameters is performed by ADCs (either integrated into the DPS components or mounted on an instrument board external to the DPS components) with sufficiently fast sample rates to capture the dynamic behavior of each rail. After capture, the parametric values are determined by post-processing the ADC data.

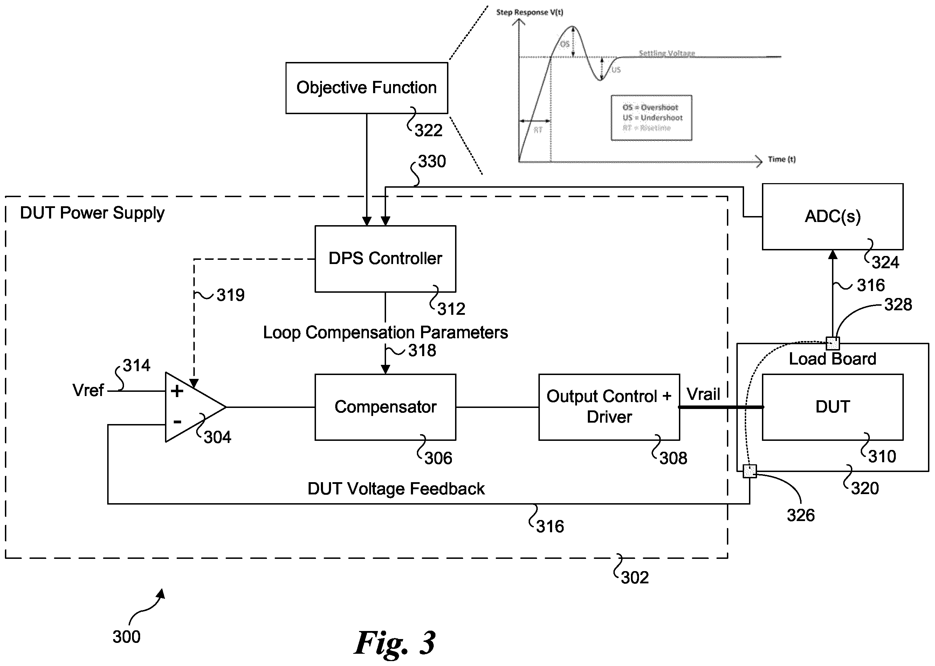

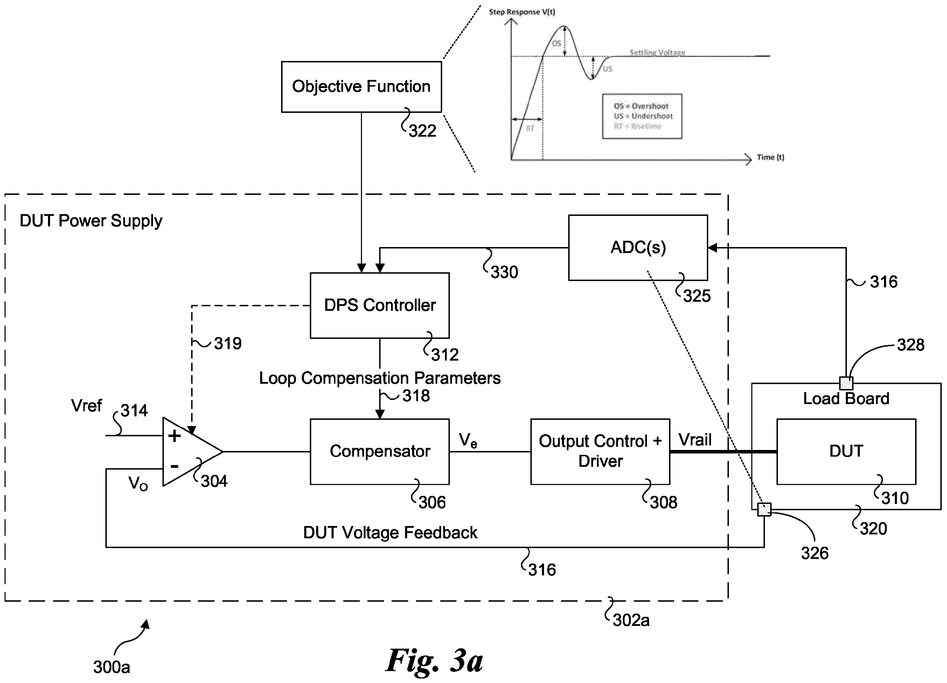

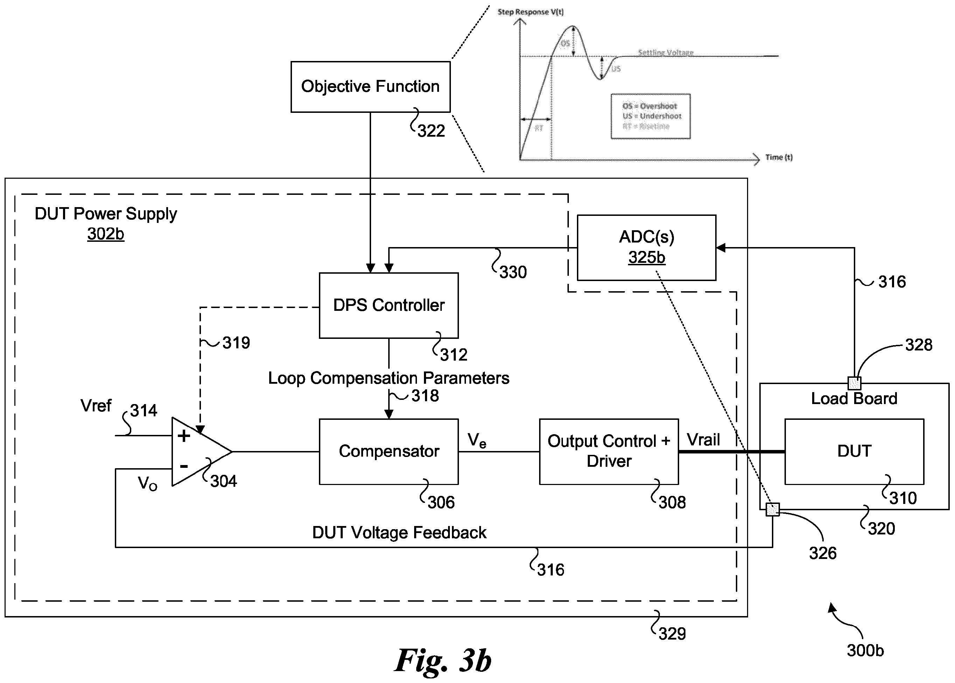

Figure 3 shows an example of a test system 300 including a DUT power supply 302 that provides an input voltage rail (Vrail) to a DUT 310 on a load board 320. DUT power supply 302 includes an amplifier 304, a compensator 306, and output control + driver block 308, and a DPS controller 312. The inputs to amplifier 304 include a reference voltage Vref and a DUT voltage feedback signal 316. DPS controller 312 provides loop compensation parameters to compensator 318, and receives inputs including an objective function 322 and one or more digitized data signals 330 from ADC(s) 324.

In the illustrated embodiment, DUT voltage feedback comprises an analog voltage signal that originates from load board 320 and corresponds to Vrail as received as an input voltage at DUT 310. Interfaces 326 and 328 are I/O (input/output) interfaces for load board 320, and represent either the same I/O interface or different I/O interfaces. An ADC 324 receives the analog DUT voltage feedback signal 316 and converts it to a digitized data signal 330; the digitized data signals may also include other digitized data converted from analog signals that originate from load board 320 and/or DUT 310.

Objective function 322 comprises the four time-based parameters that provide a measure for stability and performance of DPS instruments shown in Figure 2 and described above (Rise time, Overshoot/Undershoot, Settling time and DC error/accuracy). These values represent the target performance metrics the Vrail voltage received at DUT 310. As described above, the length and connection type/path for signals from a DUT power supply (or a DPS instrument card) may vary; these variances represent difference in impedance and potentially other signal characteristics. The objective is that the Vrail voltage reflects the voltage that would be provided to the DUT in a corresponding device installation environment (rather than on a load board). For example, for a processor or SoC, the installation environment might be a system board that is with one or more rail voltages via a power supply/subsystem, such as a might exist in a desktop or notebook computer.

Compensator 306 is used to alter the four time-based parameters of the Vrail voltage. As described and illustrated below, compensator 306 may employ circuitry employed in well-known compensator circuits, such as a Type-1, Type-2, or Type-3 compensator. Other types of compensator circuits may also be employed. In one embodiment, loop compensation parameters 318 are weighted parameters for Rise time, Overshoot/Undershoot, Settling time and DC error/accuracy.

Output control + driver block 308 is used to output a regulated Vrail voltage using known circuitry and components. For example, output control + driver block 308 may employ a conventional regulation component/circuitry, such as but not limited to a linear regulator, a buck regulator, or a switch regulator. Such circuitry for producing a regulated voltage is well-known in the art and outside the scope of this disclosure.

In some implementations, the gain of amplifier 304 may also be adjusted. For example, as shown by a dashed line 319 in Figure 3, in some embodiments DPS controller 312 can adjust the gain of amplifier 304 as part of its tuning algorithm.

Figure 3a shows a system 300a including a DUT power supply 302a including one or more ADCs 325 that are part of the DUT power supply circuitry. The input and output of ADC(s) 325 is the same as shown for ADC(s) 324 in Figure 3.

Figure 3b shows a system 300b including a DUT power supply 302b and ADC(s) 325b mounted and/or operatively coupled to a DPS instrument card 329. Under this configuration, ADC(s) 325b is external to the circuitry for DUT power supply 302b. Otherwise, the operation of systems 300a and 300b are substantially the same.

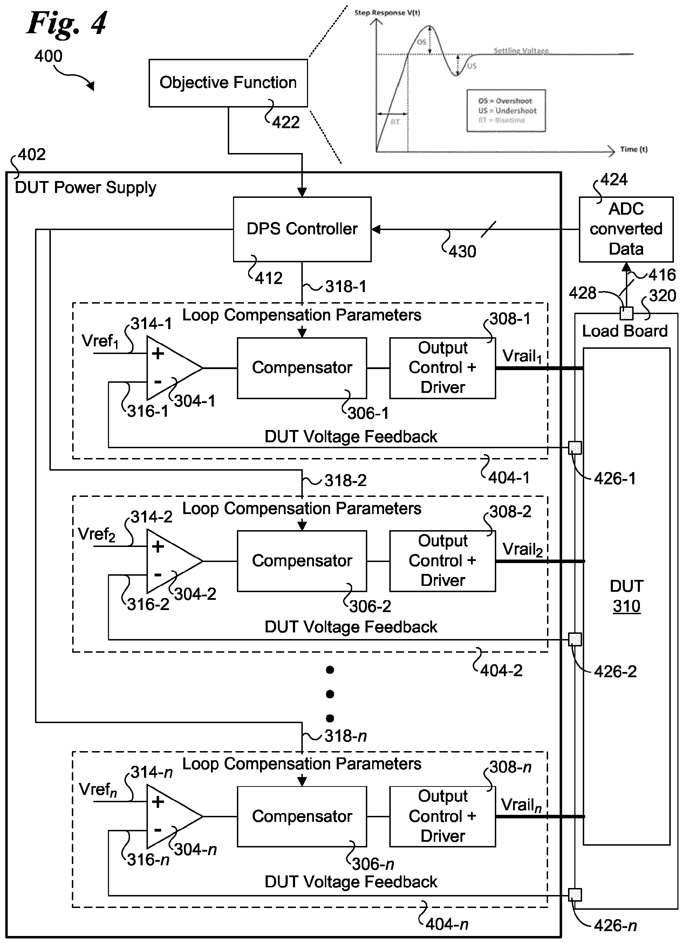

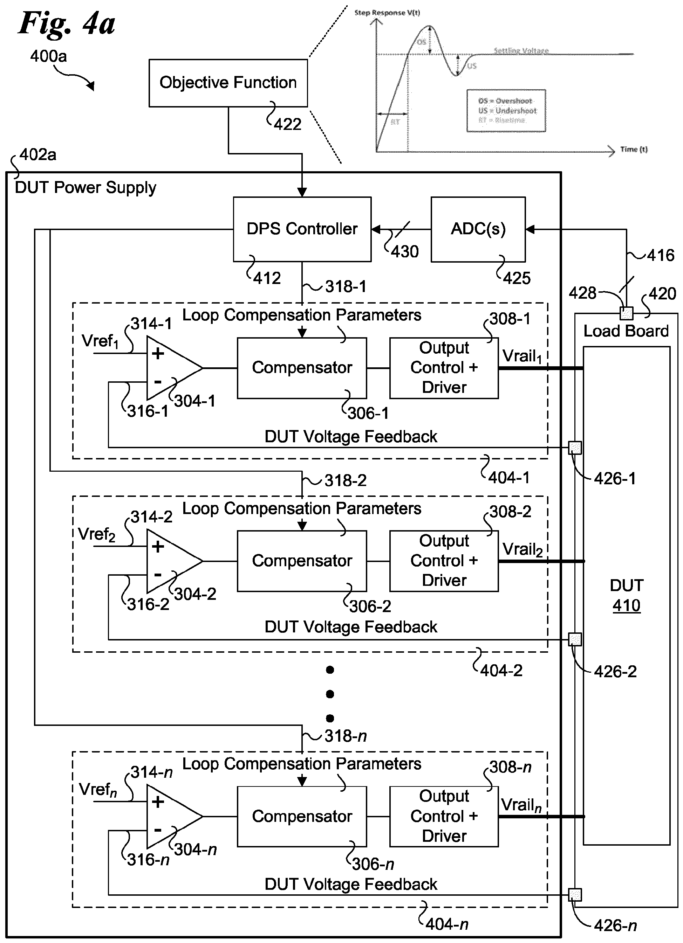

In addition to outputting a single Vrail voltage, embodiments of DUT power supplies and DPS instrument cards support multiple Vrail voltages. Examples of such configurations are shown in test systems 400 and 400a of Figures 4 and 4a. System 400 includes a DUT power supply 402 which provides *n* voltage rails (Vrail₁, Vrail₂, ... Vrail*ₙ*) to a DUT 310 on a load board 320, where *n* is 2 or more. Each of Vrail₁, Vrail₂, ... Vrail*ₙ* is output from a respective DUT voltage rail block 404-1, 404-2, ... 404-*n* having a voltage control and feedback look with a similar configuration including an amplifier 304, a compensator 306, and an output control + driver block 308. In the illustrated embodiment, a single DPS controller 412 receives target parameters for an objective function 422, and provides respective sets of loop compensation parameters 318-1, 318-2, ... 318-*n* to compensators 306-1, 318-2, ... 318-*n*. Each DUT voltage rail block 404-1, 404-2, ... 404-*n* also has a respective reference voltage Vref₁, Vref₂, Vref₃, which may represent different voltages or may be the same voltage. Meanwhile, the Vrail₁, Vrail₂, ... Vrail*ₙ* voltages are different.

Load board 320 includes multiple I/O interfaces 426-1, 426-2, ... 426-*n*, and a multichannel I/O interface 428. Multichannel I/O interface 428 may be a separate interface and/or may represent a virtual I/O interface sharing signals with one or more of I/O interfaces 426-1, 426-2, ... 426-*n*.

As shown in system 400, multiple analog signals 416 (including analog signals 316-1, 316-2, ... 316-*n* are input to ADC(s) 424, which outputs corresponding converted digitized signals 430 that are provided as inputs to DPS controller 412. Digitized signals 430 may be multiplexed over common (shared) wires or may be transmitted via separate I/O signal paths. ADC(s) 424 is representative of one or more ADCs that may be implemented external to the DUT power supply circuitry (*e.g*., on a DPS instrument card) or may be integrated with the DUT power supply circuitry, such as shown as ADC(s) 425 for DUT power supply 402a in Figure 4a.

Under an alternative configuration (not shown), a separate DPS controller is used for each DUT voltage rail block 404-1, 404-2, ... 404-*n*. Under this configuration, each DPS controller would receive a respective set of target parameters corresponding to the objective function for each DUT voltage rail block 404-1, 404-2, ... 404-*n*. Also, in some embodiments DPS controller 412 may adjust the gain of one or more of amplifiers 304-1, 304-2, ... 304-*n* in DUT voltage rail blocks 404-1, 404-2, ... 404-*n* in a manner similar to that shown in the embodiments of systems 300, 300a, and 300b in Figures 3, 3a, and 3b (not shown in Figures 4 and 4a to avoid clutter).

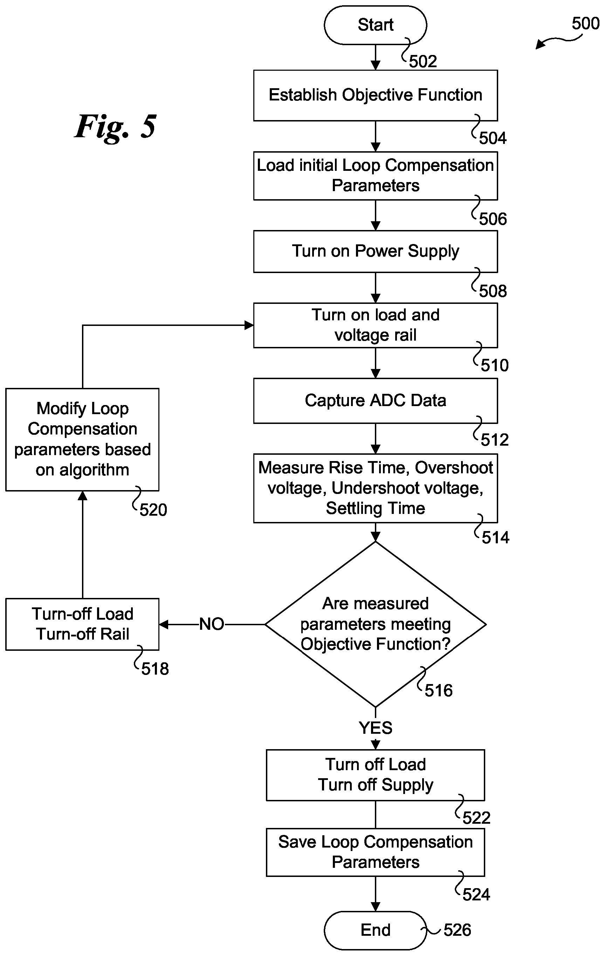

Figure 5 shows a flowchart 500 illustrating operations and logic implemented by a DPS controller, according to one embodiment. In a block 504 following start block 502, an objective function is established. As explained above, the objective function defines a set of weighted parameters defining acceptable performance for a DUT Vrail output voltage. In a block 506 an initial set of loop compensation parameters are loaded into the DPS controller. In a block 508 the power supply is turned on.

Next, a sequence of loop operations is performed to tune the characteristics of the DUT Vrail output voltage by adjusting the loop compensation parameters till the objective function is met. The loop begins in a block 510 in which the load and voltage rail are turned on, which provides power to the DUT using the current set of loop compensation parameters. In a block 512 ADC data is captured, which is used to measure the Risetime, over voltage, under voltage, and settling time of the power rail voltage.

In a decision block 516 a determination is made to whether the measured parameters are meeting the objective function. If not (answer NO), the logic flows to a block 518 in which the load and voltage rail are turned off. In a block 520 the loop compensation parameters are modified based on an algorithm that is a function of the type of compensator that is used, as explained in further detail below. The logic then returns to block 508 to turn on the load step.

The process/flow of blocks 510, 512, 514, 516, 518, and 520 are repeated until the measured parameters are determined to be meeting the objective function in decision block 516. As shown by the YES flow, the load and power supply are turned off in a block 522, the loop parameters used to meet the objective function are stored in a block 524, and the process ends in an end block 526.

When a DUT power supply provides multiple Vrail inputs to the DUT, a respective instance of the operations in flowchart 500 is implemented for each voltage rail block. This enables the multiple Vrail voltages, *e.g*., Vrail₁, Vrail₂, ... Vrail*ₙ* to be independently tuned. It is further noted that each of Vrail₁, Vrail₂, ... Vrail*ₙ* may be tuned to meet a respective objective function, observing in some instances two or more of the objective functions may be the same. While it is possible to tune multiple Vrail voltages in parallel, the operations of the respective instance of the operations of flowchart 500 will usually be used to tune the Vrail voltages one at a time.

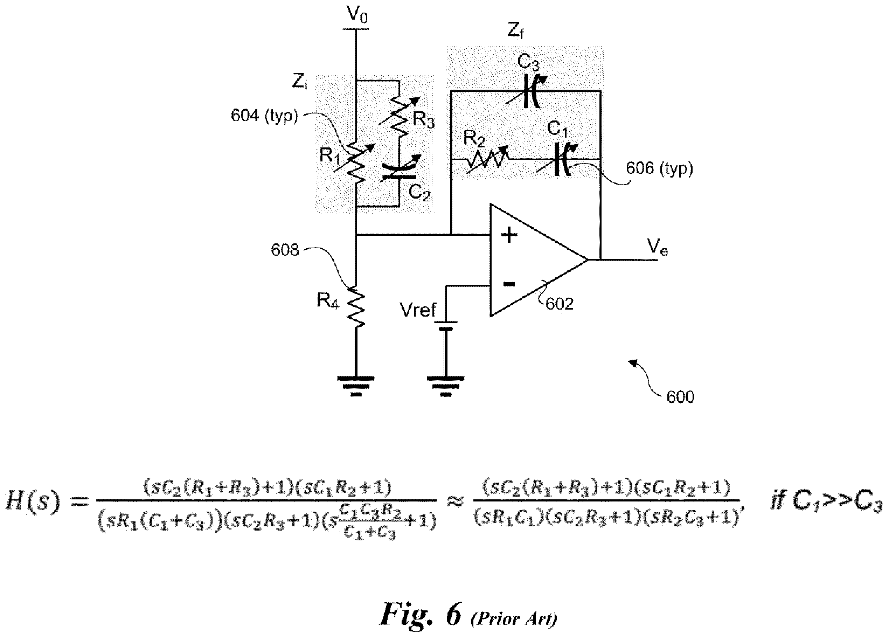

The loop compensation parameters are used to adjust the resistance and capacitance values of corresponding adjustable resistors and capacitors in the compensation circuit. For example, Figure 6 shows one embodiment of a Type-3 compensator circuit 600 as known in the art. Type-3 compensator circuit 600 includes a voltage operational amplifier (op-amp) 602, 3 variable resistors 604 (labeled R₁, R₂, and R₃), and 3 variable capacitors 606 (labeled C₁, C₂, and C₃), and a fixed resistor 608 (labeled R₄). One of the inputs of op-amp 602 is tied to a reference voltage (Vref). The voltage at the top left of the diagram, Vₒ, is an output voltage. The voltage output from op-amp 602 is an error voltage Vₑ.

Zᵢ and Z_{f} respectively represent input and feedback impedances whose RC characteristics are a function of the resistance values for R₁, R₂, and R₃ and the capacitance values for C₁, C₂, and C₃. The transfer function, *H(s)*, for Type-3 compensator circuit 600 can be mathematically modeled based on the resistance values for R₁, R₂, and R₃ and the capacitance values for C₁, C₂, and C₃; the transfer function equation for *H(s)* when C₁>>C₃ is shown at the lower portion of Figure 6. By adjusting these values, which comprise inputs to a compensator 306 employing Type-3 compensator circuit 600, the time/frequency-based characteristics of the DUT rail voltage can be adjusted until the objective function is met.

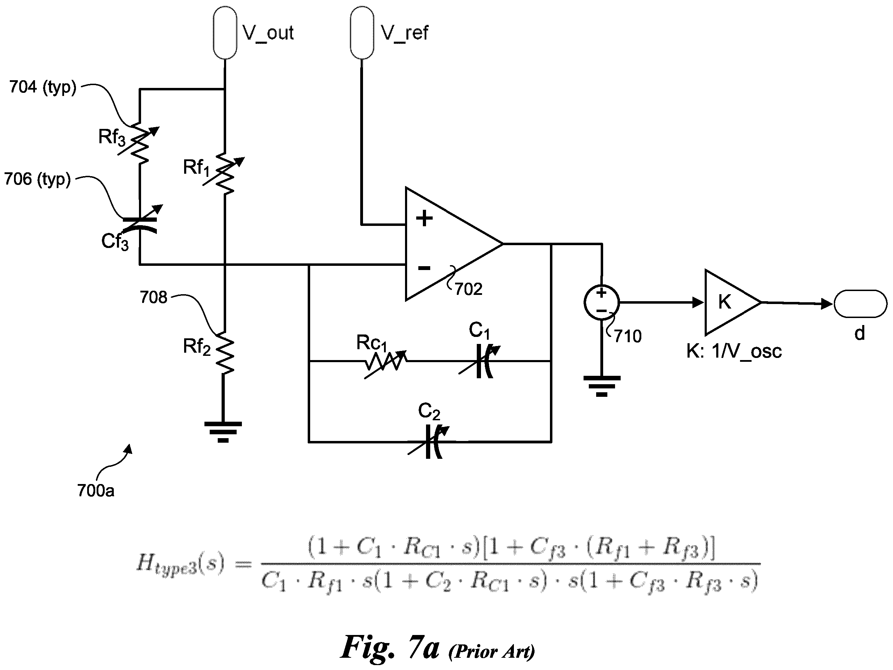

Figure 7a shows another example of a Type-3 compensator circuit 700a as known in the art. Type-3 compensator circuit 700a includes an op-amp 702, 3 variable resistors 704 (labeled Rf₁, Rf₃, and Rc₁), and 3 variable capacitors 706 (labeled C₁, C₂, and Cf₃), and a fixed resistor 708 (labeled Rf₂). One of the inputs of op-amp 602 is tied to a reference voltage (V_ref). The voltage at the top left of the diagram, V_out, is an output voltage. The voltage output from op-amp 702 is supplied as an input to a DC voltage source 710. The transfer function, *H_{type3}(s),* for Type-3 compensator circuit 700a can be mathematically modeled based on the resistance values for Rf₁, Rf₃, and Rc₁ and the capacitance values for C₁, C₂, and Cf₃; the transfer function equation for *H_{type3}(s)* is shown at the lower portion of Figure 7a. By adjusting these values, which comprise inputs to a compensator employing Type-3 compensator circuit 700b, the time/frequency-based characteristics of the DUT rail voltage can be adjusted until the objective function is met.

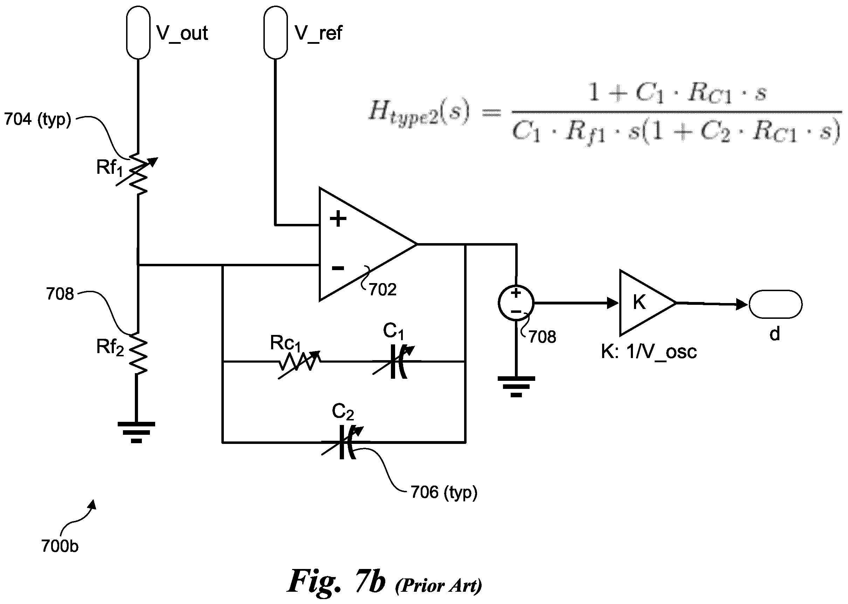

As mentioned above, various types of compensator circuits may be used, including a Type-2 compensator. Figure 7b shows an example of a Type-2 compensator circuit 700b as known in the art. Type-2 compensator circuit 700b is similar to Type-3 compensator circuit 700a except the lefthand branches are different. Type-2 compensator circuit 700b includes an op-amp 702, 2 variable resistors 704 (labeled Rf₁, and Rc₁), 2 variable capacitors 706 (labeled C₁, C₂), and a fixed resistor 708 (labeled Rf₂). One of the inputs of op-amp 602 is tied to a reference voltage (V_ref). The voltage at the top left of the diagram, V_out, is an output voltage. The voltage output from op-amp 602 is supplied as an input to a DC voltage source 710. The transfer function, *H_{type2}(s)*, for Type-2 compensator circuit 700b can be mathematically modeled based on the resistance values for Rf₁ and Rc₁ and the capacitance values for C₁ and C₂; the transfer function equation for *H*_{*type*2}*(s)* is shown at the upper right-hand portion of Figure 7b. By adjusting these values, which comprise inputs to a compensator 702 employing Type-2 compensator circuit 700b, the time/frequency-based characteristics of the DUT rail voltage can be adjusted until the objective function is met.

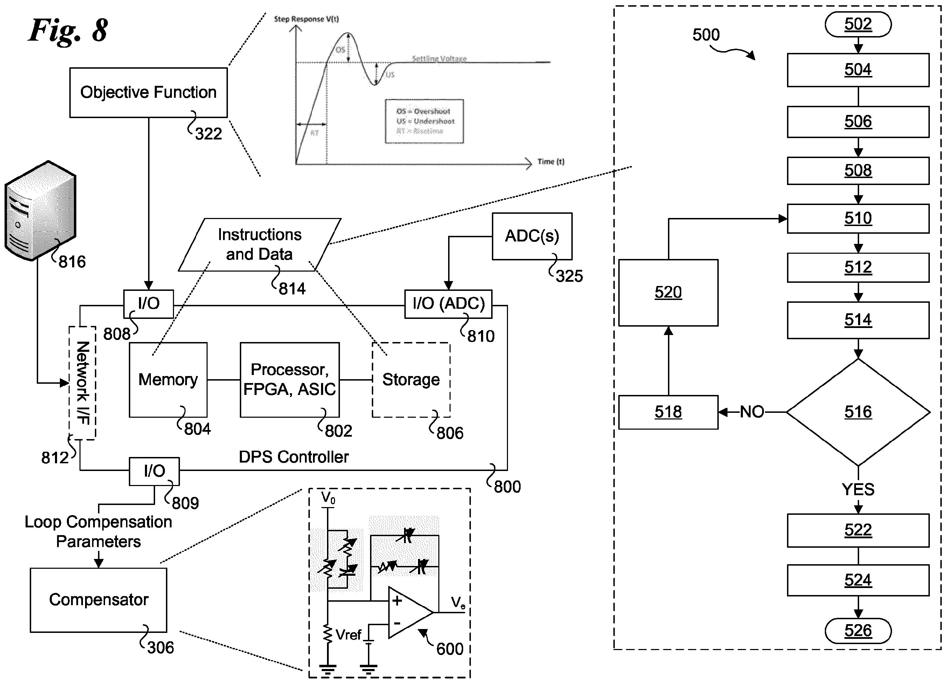

Figure 8 shows further details of a DPS controller 800, according to one embodiment. In one aspect, DPS controller includes embedded logic for implementing the operations of flowchart 500. The embedded logic may comprise instructions (*e.g*., machine code) executed on one or more processing elements such as a processor, microcontroller, *etc.,* via programmed or programmable hardware logic, such as a Field Programmable Gate Array or Application Specific Integrated Circuit (ASIC), or employ a combination of these approaches. Accordingly, DPS controller 800 is depicted as including a component 802 comprising one or more of an embedded processor, FPGA, and ASIC coupled to memory 804 and optional storage 806. DPS controller 800 further includes multiple I/O interfaces, including I/O interfaces 808 and 809, an I/O (ADC) interface 810, and an optional network interface 812. When component 802 is an embedded processor or microcontroller, the operations of flowchart 500 may be implemented by instructions that are executed on the embedded processor or microcontroller, with the instruction operating on associated data, as depicted by instructions and data 814. These instructions and data may be provided to DPS controller 800 and loaded into memory 804 and/or be stored in storage 806 and loaded into memory. Some types of processors or microcontrollers may employ a System on a Chip (Soc) architecture that may include one or more I/O interfaces, onboard memory, and/or onboard storage.

In some implementations, instructions, and data 814 are provided by a server 816 that is connected in communication with DPS controller via network interface 812. Under another approach, the instrument card on which DPS controller is installed has a network interface or the like and instructions and data 814 are received from server at the DPS instrument card and forward via wiring and interfaces on the instrument card to DPS controller 800. Under yet another approach, the test unit chassis in which the DPS instrument card is installed provides some means for communicating with server 816 and the DPS instrument card.

When component 802 is an FPGA, the FPGA may be pre-programmed or dynamically programmed using conventional FPGA programming techniques, such as sending an FPGA bitstream to DPS controller 800. Some FPGAs include onboard memory, which may be used in place of memory 804, while other FPGAs include memory interfaces for interfacing with external memory, such as memory 804.

As further shown in Figure 8, DPS controller 800 receives target parameters associated with objective function 322 via I/O interface 808. Objective function parameters, including weighted parameters also may be loaded from server 816.

During tuning operation, digitized voltage signal data will be received from ADC(s) 325 at I/O (ADC) interface 810 and processed by the embedded logic in DPS controller. The embedded logic will include an algorithm for generating the loop compensation parameters, which are provided to compensator circuitry 306 via I/O interface 809. For example, the algorithm may include a model of the transfer function for the compensator circuitry, such as illustrated by Type-3 compensator circuitry 600 in this example.

Generally, the control loops described and illustrated herein may be implemented as analog control loops, digital control loops, or using a combination of analog and digital components. In addition to the analog compensators described and illustrated above, a digital compensator may be used in some embodiments. Alternatively, the compensators may employ a combination of analog and digital components.

In the foregoing embodiments some components and associated circuitry have been shown in blocks for convenience and point of illustration. The delineations of the blocks are exemplary and not limiting. For example, one skilled in the art will recognize that circuit elements in multiple blocks may be combined into a die or the like for a single discrete component, such as an integrated circuit (IC) chip. In some embodiments, one or more of the voltage rail blocks may be implemented on a single discrete component that may or may not include a DPS controller. For example, the DPS controller may comprise a microcontroller, processor, or the like that is coupled to an IC chip with the one or more voltage rail blocks or the voltage rail blocks may be implemented on individual IC chips or other integrated packages.

While various embodiments described herein use the term System-on-a-Chip or System-on-Chip ("SoC") to describe a device or system having a processor and associated circuitry (*e.g*., I/O circuitry, power delivery circuitry, memory circuitry, *etc.*) integrated monolithically into a single Integrated Circuit ("IC") die, or chip, the present disclosure is not limited in that respect. For example, in various embodiments of the present disclosure, a device or system can have one or more processors (*e.g*., one or more processor cores) and associated circuitry (*e.g*., I/O circuitry, power delivery circuitry, *etc.*) arranged in a disaggregated collection of discrete dies, tiles and/or chiplets (*e.g*., one or more discrete processor core die arranged adjacent to one or more other die such as memory die, I/O die, *etc.*)*.* In such disaggregated devices and systems, the various dies, tiles and/or chiplets can be physically and electrically coupled together by a package structure including, for example, various packaging substrates, interposers, active interposers, photonic interposers, interconnect bridges and the like. The disaggregated collection of discrete dies, tiles, and/or chiplets can also be part of a System-on-Package ("SoP").

Although some embodiments have been described in reference to particular implementations, other implementations are possible according to some embodiments. Additionally, the arrangement and/or order of elements or other features illustrated in the drawings and/or described herein need not be arranged in the particular way illustrated and described. Many other arrangements are possible according to some embodiments.

In each system shown in a figure, the elements in some cases may each have a same reference number or a different reference number to suggest that the elements represented could be different and/or similar. However, an element may be flexible enough to have different implementations and work with some or all the systems shown or described herein. The various elements shown in the figures may be the same or different. Which one is referred to as a first element and which is called a second element is arbitrary.

In the description and claims, the terms "coupled" and "connected," along with their derivatives, may be used. It should be understood that these terms are not intended as synonyms for each other. Rather, in particular embodiments, "connected" may be used to indicate that two or more elements are in direct physical or electrical contact with each other. "Coupled" may mean that two or more elements are in direct physical or electrical contact. However, "coupled" may also mean that two or more elements are not in direct contact with each other, but yet still co-operate or interact with each other. Additionally, "communicatively coupled" means that two or more elements that may or may not be in direct contact with each other, are enabled to communicate with each other. For example, if component A is connected to component B, which in turn is connected to component C, component A may be communicatively coupled to component C using component B as an intermediary component.

An embodiment is an implementation or example of the inventions. Reference in the specification to "an embodiment," "one embodiment," "some embodiments," or "other embodiments" means that a particular feature, structure, or characteristic described in connection with the embodiments is included in at least some embodiments, but not necessarily all embodiments, of the inventions. The various appearances "an embodiment," "one embodiment," or "some embodiments" are not necessarily all referring to the same embodiments.

Not all components, features, structures, characteristics, *etc.* described and illustrated herein need be included in a particular embodiment or embodiments. If the specification states a component, feature, structure, or characteristic "may", "might", "can" or "could" be included, for example, that particular component, feature, structure, or characteristic is not required to be included. If the specification or claim refers to "a" or "an" element, that does not mean there is only one of the element. If the specification or claims refer to "an additional" element, that does not preclude there being more than one of the additional element.

An algorithm is here, and generally, considered to be a self-consistent sequence of acts or operations leading to a desired result. These include physical manipulations of physical quantities. Usually, though not necessarily, these quantities take the form of electrical or magnetic signals capable of being stored, transferred, combined, compared, and otherwise manipulated. It has proven convenient at times, principally for reasons of common usage, to refer to these signals as bits, values, elements, symbols, characters, terms, numbers or the like. It should be understood, however, that all of these and similar terms are to be associated with the appropriate physical quantities and are merely convenient labels applied to these quantities.

Italicized letters, such as '*n*' in the foregoing detailed description are used to depict an integer number, and the use of a particular letter is not limited to particular embodiments. Moreover, the same letter may be used in separate claims to represent separate integer numbers, or different letters may be used. In addition, use of a particular letter in the detailed description may or may not match the letter used in a claim that pertains to the same subject matter in the detailed description.

As discussed above, various aspects of the embodiments herein may be facilitated by corresponding software and/or firmware components and applications, such as software and/or firmware executed by an embedded processor or the like. Thus, embodiments of this invention may be used as or to support a software program, software modules, firmware, and/or distributed software executed upon some form of processor, processing core, or embedded logic, or a virtual machine running on a processor or core or otherwise implemented or realized upon or within a non-transitory computer-readable or machine-readable storage medium. A non-transitory computer-readable or machine-readable storage medium includes any mechanism for storing or transmitting information in a form readable by a machine (*e.g*., a computer). For example, a non-transitory computer-readable or machine-readable storage medium includes any mechanism that provides (*i.e*., stores and/or transmits) information in a form accessible by a computer or computing machine (*e.g*., computing device, electronic system, *etc*.), such as recordable/non-recordable media (*e.g*., read only memory (ROM), random access memory (RAM), magnetic disk storage media, optical storage media, flash memory devices, *etc.*)*.* The content may be directly executable ("object" or "executable" form), source code, or difference code ("delta" or "patch" code). A non-transitory computer-readable or machine-readable storage medium may also include a storage or database from which content can be downloaded. The non-transitory computer-readable or machine-readable storage medium may also include a device or product having content stored thereon at a time of sale or delivery. Thus, delivering a device with stored content, or offering content for download over a communication medium may be understood as providing an article of manufacture comprising a non-transitory computer-readable or machine-readable storage medium with such content described herein.

The operations and functions performed by various components described herein may be implemented by software running on a processing element, via embedded hardware or the like, or any combination of hardware and software. Such components may be implemented as software modules, hardware modules, special-purpose hardware (*e.g*., application specific hardware, ASICs, DSPs, *etc.*), embedded controllers, hardwired circuitry, hardware logic, *etc.* Software content (*e.g*., data, instructions, configuration information, *etc.*) may be provided via an article of manufacture including non-transitory computer-readable or machine-readable storage medium, which provides content that represents instructions that can be executed. The content may result in a computer performing various functions/operations described herein.

As used herein, a list of items joined by the term "at least one of" can mean any combination of the listed terms. For example, the phrase "at least one of A, B or C" can mean A; B; C; A and B; A and C; B and C; or A, B and C.

The above description of illustrated embodiments of the invention, including what is described in the Abstract, is not intended to be exhaustive or to limit the invention to the precise forms disclosed. While specific embodiments of, and examples for, the invention are described herein for illustrative purposes, various equivalent modifications are possible within the scope of the invention, as those skilled in the relevant art will recognize.

These modifications can be made to the invention in light of the above detailed description. The terms used in the following claims should not be construed to limit the invention to the specific embodiments disclosed in the specification and the drawings. Rather, the scope of the invention is to be determined entirely by the following claims, which are to be construed in accordance with established doctrines of claim interpretation.

## Claims

1. A device under test (DUT) power supply (DPS) apparatus, configured to provide one or more voltage inputs to a DUT installed in a load board, comprising:
a voltage rail block, including,
an amplifier having a first input comprising a reference voltage and a second input comprising a DUT voltage feedback;
compensator circuitry, coupled to an output from the amplifier, the compensator having adjustable capacitors and adjustable resistors;
an output control and driver block, having an input coupled to an output of the compensator and generating a voltage output comprising a voltage rail; and
a first input/output (I/O) interface to receive, from the load board, a first voltage signal corresponding to the voltage rail input to the DUT, the first voltage signal comprising the DUT voltage feedback; and
a DPS controller, to receive a digitized voltage signal corresponding to the DUT voltage feedback and provide loop compensation parameters to adjust the adjustable capacitors and the adjustable resistors in the compensator circuitry to tune the voltage rail.

2. The DPS apparatus of claim 1, further comprising:
a second I/O interface to receive a second voltage signal corresponding the voltage rail received at the DUT from the load board; and
an analog-to-digital convertor (ADC) coupled to the second I/O interface and coupled to the DPS controller, to convert the second voltage signal to the digitized voltage signal received by the DPS controller.

3. The DPS apparatus of claim 1 or 2, wherein the DPS controller is further configured to:
receive parameters associated with an objective function defining one or more characteristics of the voltage rail; and
use the received parameters, the digitized voltage signal, and a model of a transfer function for the compensator circuitry to generate loop compensation parameters to tune the voltage rail to meet the objective function.

4. The DPS apparatus of claim 3, wherein the one or more characteristics comprise two or more of a voltage rise time, a voltage overshoot, a voltage undershoots, and a settling time.

5. The DPS apparatus of any of the preceding claims, wherein the compensator circuitry comprises a Type-2 or Type-3 compensator circuit.

6. An instrument card configured to be installed in a chassis of a test unit that is used to test a Device under Test (DUT) installed on a load board, comprising:
a DUT power supply (DPS), configured to supply one or more voltage inputs to the DUT, having:
a voltage rail block, including,
an amplifier having a first input comprising a reference voltage and a second input comprising a DUT voltage feedback;
compensator circuitry, coupled to an output from the amplifier, the compensator having adjustable capacitors and adjustable resistors;
an output control and driver block, having an input coupled to an output of the compensator and generating a voltage output comprising a voltage rail; and
a first input/output (I/O) interface to receive, from the load board, a first voltage signal corresponding to the voltage rail input to the DUT, the first voltage signal comprising the DUT voltage feedback; and
an Analog-to-Digital Convertor (ADC), to receive the first voltage signal and output a digitized voltage signal corresponding to the DUT voltage feedback; and
a DPS controller, to receive the digitized voltage signal and provide loop compensation parameters to adjust the adjustable capacitors and the adjustable resistors in the compensator circuitry to tune the voltage rail.

7. The instrument card of claim 6, wherein the DPS controller is further configured to:
receive parameters associated with an objective function defining one or more characteristics of the voltage rail; and
use the received parameters, the digitized voltage signal, and a model of a transfer function for the compensator circuitry to generate loop compensation parameters to tune the voltage rail to meet the objective function.

8. The instrument card of claim 7, wherein the one or more characteristics comprise two or more of a voltage rise time, a voltage overshoot, a voltage undershoots, and a settling time.

9. The instrument card of claim 7 or 8, wherein the DPS controller is configured to implement an algorithm with a loop to tune the output voltage rail, comprising:
a) turning on a load and voltage rail during which the output voltage rail is provided as a power input to the DUT;
b) capturing the digitized voltage signal;
c) measuring characteristics of the digitized voltage signal defined by the objective function;
d) determine, based on the measured characteristics, if the objective function is met; and
e) when the objective function is not met,
i. turning off the load and the voltage rail;
ii. modifying loop compensation parameters based, in part, on the measured characteristics and using the model of the transfer function for the compensator circuitry; and
iii. looping back to operation a),
wherein the foregoing operations are repeated until it is determined in operation d) the objective function has been met.

10. The instrument card of any of claims 6-9, wherein the voltage rail block comprises a first voltage rail block to output a first voltage rail Vrail₁, further comprising:
a second voltage rail block including,
a second amplifier having a first input comprising a reference voltage and a second input comprising a second DUT voltage feedback;
a second compensator circuitry, coupled to an output from the second amplifier, the second compensator having adjustable capacitors and adjustable resistors;
a second output control and driver block, having an input coupled to an output of the second compensator and generating a voltage output comprising a second voltage rail Vrail₂; and
a second I/O interface to receive, from the load board, a second voltage signal corresponding to the Vrail₂ input to the DUT, the second voltage signal comprising the second DUT voltage feedback; and
wherein the DPS controller or a second DPS controller is configured to receive a second digitized voltage signal corresponding to the second DUT voltage feedback and provide loop compensation parameters to adjust the adjustable capacitors and the adjustable resistors in the second compensator circuitry to tune Vrail₂.

11. A method for providing one or more rail voltages to a Device under Test (DUT), comprising:
for each rail voltage;
generating the rail voltage using a respective rail voltage circuit block employing a feedback loop and having an amplifier including a reference voltage input and a DUT voltage feedback input, compensator circuitry, and an output block to output the rail voltage; and
automatically adjusting the compensator circuitry via embedded logic in the rail voltage circuit block to tune the rail voltage to meet an objective function defining characteristics of the rail voltage at an input of the DUT to be met.

12. The method of claim 11, wherein the characteristics of the rail voltage defined by the objective function include two or more of two or more of a voltage rise time, a voltage overshoot, a voltage undershoots, and a settling time.

13. The method of claim 11 or 12, wherein the characteristics of the rail voltage defined by the objective function include a voltage rise time, a voltage overshoot, a voltage undershoots, and a settling time.

14. The method of any of claims 11-13, wherein the compensator circuitry includes adjustable capacitors and adjustable resistors that are adjusted by embedded logic comprising one or more of:
instructions executed on one or more processing elements;
a Field Programmable Gate Array; and
an Application Specific Integrated Circuit.

15. The method of claim 19, wherein embedded logic is configured to implement an algorithm with a loop to tune an output voltage rail, comprising:
a) turning on a load and voltage rail during which the output voltage rail is provided as a power input to the DUT;
b) capturing a digitized voltage signal;
c) measuring characteristics of the digitized voltage signal defined by the objective function;
d) determine, based on the measured characteristics, if the objective function is met; and
e) when the objective function is not met,
i. turning off the load and the voltage rail;
ii. modifying loop compensation parameters based, in part, on the measured characteristics and using a model of the transfer function for the compensator circuitry; and
iii. looping back to operation a),
wherein the foregoing operations are repeated until it is determined in operation d) the objective function has been met.
